# EUROPEAN PATENT APPLICATION

(11) **EP 4 664 099 A1**
(43) Date of publication of application: **17.12.2025**
(21) Application number: 24829716.0
(22) Date of filing: 08.01.2024
(51) Int. Cl.: G01N 21/88, G01N 23/04, G01N 23/02, G01N 23/18

(54) **TESTING APPARATUS AND BATTERY PRODUCTION DEVICE**

(30) Priority: 30.06.2023 CN 202321704186 U
(71) Applicant: Contemporary Amperex Technology Co., Limited, Ningde, Fujian 352100 (CN)
(72) Inventor: SHI, Zhimeng, Ningde, Fujian 352100 (CN); ZHANG, Tao, Ningde, Fujian 352100 (CN); ZHOU, Xiaofeng, Ningde, Fujian 352100 (CN); LIU, Jianlin, Ningde, Fujian 352100 (CN)
(74) Representative: Lorenz Seidler Gossel Part. mbB
(86) International application number: PCT/CN2024/071137
(87) International publication number: WO 2025/001053

(57) **Abstract**

A testing apparatus (400) and a battery production device, which belong to the technical field of batteries. The testing apparatus (400) comprises an X-ray source (410), a linear array detector (420) and a carrying platform (430). The linear array detector (420) is opposite an emission port of the X-ray source (410), the carrying platform (430) can move in a first direction Y, a movement trajectory of the carrying platform (430) passes between the X-ray source (410) and the linear array detector (420), and the carrying platform (430) is configured to carry a battery (500) to be tested. The linear array detector (420) comprises a plurality of columns of sensing regions (421), which are arranged in the first direction Y. The testing apparatus (400) provided can test the battery (500) and improve the testing efficiency.

## Description

### CROSS-REFERENCE

The present application refers to the Chinese Patent Application No. 202321704186.X entitled "TESTING APPARATUS AND BATTERY PRODUCTION DEVICE" filed on June 30, 2023, which is incorporated herein by reference in its entirety.

### TECHNICAL FIELD

The present application relates to the field of battery technology, and in particular, to a testing apparatus and a battery production device.

### BACKGROUND

Energy conservation and emission reduction are keys to sustainable development of the automobile industry. Electric vehicles have become an important part of the sustainable development of the automobile industry due to their energy-saving and environment-friendly advantages. For electric vehicles, the battery technology is an important factor in their development.

Various internal defects may be generated in the production process of batteries and may affect the quality and reliability of the batteries. In the production process of the batteries, it is necessary to perform defect tests on batteries to exclude unqualified batteries. Current internal defect tests in batteries feature poor efficiency, thus affecting the efficiency of battery production.

### SUMMARY

The present application is intended to solve at least one of the technical problems in the prior art. To this end, one objective of the present application is to provide a testing apparatus and a battery production device to improve the efficiency of battery defect tests.

Embodiments of a first aspect of the present application provide a testing apparatus. The testing apparatus includes: an X-ray source; a linear array detector opposite to an exit of the X-ray source, the linear array detector comprising a plurality of sensing regions arranged in a first direction; and a carrying platform movable in the first direction, the carrying platform moving in a trajectory traversing between the X-ray source and the linear array detector and being configured to carry a battery under test.

In the technical solution of the embodiments of the present application, the battery under test is carried by the carrying platform. During the test process, the battery under test moves along with the carrying platform in the first direction Y. When the battery under test moves to a position between the X-ray source and the linear array detector, the X-ray emitted by the X-ray source passes through the battery under test and then is detected by the linear array detector, thereby achieving the test of the battery under test. Also, since the movement direction of the battery under test is the same as the arrangement direction of the plurality of sensing regions, the battery under test will pass over each sensing region during the movement process. The battery under test is tested during the movement process of the battery under test without staying for detection, thereby reducing the test time and improving the test efficiency.

In some embodiments, the number N of the plurality of sensing regions satisfies: 50 ≤ N ≤ 1100. A greater number of the sensing regions in the linear array detector may result in a longer analysis time of detection images and a lower test efficiency, while a smaller number of the sensing regions in the linear array detector may lead to worse effects in acquired detection images and thus affected accuracy of the test results. In the embodiments of the present application, defining the number N of the plurality of sensing regions can improve the accuracy of the test results while the analysis time of detection images and thus improving the test efficiency.

In some embodiments, the number N of the plurality of sensing regions satisfies: 200 ≤ N ≤ 600. In some embodiments, defining the number N of the plurality of sensing regions can improve the accuracy of the test results while the analysis time of detection images and thus improving the test efficiency.

In some embodiments, the moving speed V of the carrying platform satisfies: 10 mm/s ≤ V ≤ 400 mm/s. Thus, the occurrence of undersampling and oversampling may be reduced to a certain extent, thereby improving the quality of detection images and the test effect.

In some embodiments, the moving speed V of the carrying platform satisfies: 30 mm/s ≤ V ≤ 250 mm/s. In some embodiments, defining the moving speed V of the carrying platform can reduce the occurrence of undersampling and oversampling to a certain extent, thereby improving the quality of detection images and the test effect.

In some embodiments, the power P of the X-ray source satisfies: 65 W ≤ P ≤ 75 W. Thus, the resolution of the linear array detector and the brightness of detection images can be improved to a certain extent, thereby lifting method the accuracy of the test.

In some embodiments, the power P of the X-ray source satisfies: 68 W ≤ P ≤ 72 W. In some embodiments, defining the power P of the X-ray source can improve the resolution of the linear array detector and the brightness of detection images, thereby lifting method the accuracy of the test.

In some embodiments, the rated voltage U of the X-ray source satisfies: 100 kV ≤ U ≤ 160 kV, and/or the rated current I of the X-ray source satisfies: I ≤ 500 µA. Defining the rated voltage U or the rated current I of the X-ray source can provide a test X-ray dose that meets the requirements, ensure the stability and reliability of the X-ray source, and enable the coordination of the X-ray source with the linear array detector to meet requirements for the test precision of batteries under test with a greater thickness range, thereby improving the test efficiency and accuracy.

In some embodiments, the rated voltage U of the X-ray source satisfies: 130 kV ≤ U ≤ 150 kV, and/or the rated current I of the X-ray source satisfies: I ≤ 400 µA. Defining the rated voltage U or the rated current I of the X-ray source can increase the dose of X-ray emitted by the X-ray source and improve the stability and reliability of the X-ray source, thereby improving the efficiency and accuracy of the test.

In some embodiments, the maximum size D1 of the focal spot of the X-ray source satisfies: D1 ≤ 30 µm. The maximum size D1 of the focal spot is directly related to the image resolution of the battery testing apparatus. Defining the maximum size D1 allows a better match of the test precision of the battery testing apparatus with the size of the battery under test, thereby improving the test accuracy and the test efficiency.

In some embodiments, the maximum size D1 of the focal spot of the X-ray source satisfies: D1 ≤ 10 µm. Defining the maximum size D1 of the focal spot can improve the test accuracy and the test efficiency.

In some embodiments, the width D2 of each sensing region in the plurality of sensing regions satisfies: 50 µm ≤ D2 ≤ 150 µm. When the size of the linear array detector changes, a greater width D2 of the sensing region may lead to a shorter integration time and reduced total test time, thereby improving the test efficiency. A smaller width D2 of the sensing region may result in a relatively greater number of the sensing regions and an improved enhancement effect on detection images, thereby increasing the signal-to-noise ratio in detection images of the battery under test. In the embodiments of the present application, defining the width D2 of the sensing region can improve the signal-to-noise ratio in detection images while improving the test efficiency.

In some embodiments, the X-ray source includes an integrated X-ray source. The integrated X-ray source is a closed X-ray source with an integrated design where the cathode and the anode/target are both enclosed in a vacuum tube, so as to improve the stability and reduce the failure rate, while minimizing the volume of the X-ray source to facilitate the operation and mounting.

In some embodiments, the linear array detector includes a TDI detector. The TDI detector has a better imaging effect, which makes the detection image closer to the real situation and thus improves the test precision. In addition, the TDI detector can output images with high quality even in a dark circumstance, which may further improve the test precision.

Embodiments of a second aspect of the present application provide a battery production device. The battery production device includes the testing apparatus according to any one of the above embodiments.

The above description is only an overview of the technical solutions of the present application. To more clearly understand the technical means of the present application to enable implementation in accordance with the content of the specification and to make the above and other purposes, features, and advantages of the present application easier to understand, the detailed description of the present application is provided below.

### BRIEF DESCRIPTION OF THE DRAWINGS

In the drawings, unless otherwise specified, the same reference numerals across multiple accompanying drawings indicate the same or similar components or elements. The drawings are not necessarily drawn to scale. It will be appreciated that the accompanying drawings depict only some embodiments of the present application and are therefore not to be considered as limiting the scope of the present application. To more clearly illustrate the technical solutions in the embodiments of the present application, the drawings required for illustrating the embodiments of the present application are briefly described below. Apparently, the drawings in the following description illustrate merely some embodiments of the present application, and those of ordinary skills in the art may still derive other drawings from these drawings without creative efforts.
FIG. 1 is a schematic view of a vehicle according to some embodiments of the present application;
FIG. 2 is an exploded view of a battery according to some embodiments of the present application;
FIG. 3 is an exploded view of a battery according to some embodiments of the present application;
FIG. 4 is a schematic view of a testing apparatus according to some embodiments of the present application;
FIG. 5 is a top view of a linear array detector according to some embodiments of the present application;
FIG. 6 is a flowchart of a test method of the testing apparatus according to some embodiments of the present application.

Description of the reference numerals:
1000: vehicle; 100: battery; 200: controller; 300: motor; 10: case; 11: first part; 12: second part; 20: battery cell; 21: end cover; 21a: electrode terminal; 22: housing; 23: electrode assembly; 23a: tab; 400: testing apparatus; 410: X-ray source; 420: linear array detector; 421: sensing region; 430: carrying platform; 500: battery under test.

### DETAILED DESCRIPTION

Embodiments of the technical solutions of the present application will be described in detail below with reference to the drawings. The following embodiments are only used to more clearly illustrate the technical solutions of the present application, and therefore, are only exemplary and do not limit the claimed scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", and "provided with", and any variations thereof in the description and claims of the present application and the above drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality" refers to two or more (including two). Similarly, "plurality of groups" refers to two or more (including two) groups, and "plurality of pieces" refers to two or more (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicate orientations or positional relationships based on those shown in the drawings. They are merely for the convenience of describing the present application and simplifying the description, rather than indicating or implying that the apparatus or element referred to must have a specific orientation or be constructed and operated in the specific orientation, and thus should not be construed as a limitation to the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application can be interpreted according to the specific conditions.

At present, judging from the trends in the market, the application of power batteries is becoming increasingly widespread. Power batteries are not only applied to energy storage power systems such as hydropower, thermal power, wind power, and solar power stations, but are also widely applied to electric transportation vehicles such as electric bicycles, electric motorcycles, or electric cars, as well as in military equipment, aerospace, and other fields. With the continuous expansion of the application field of power batteries, the market demand for power batteries is also constantly increasing.

Taking a lithium-ion battery as an example, gaps and overhangs between the cathode electrode plate and the anode electrode plate inside a battery are important factors affecting the safety performance of a wound battery cell. For gaps between the cathode electrode plate and the anode electrode plate: in the charging and discharging process of a lithium-ion battery, an excessive gap between the cathode electrode plate and the anode electrode plate may lead to incomplete intercalation of lithium ions in the anode channels and the occurrence of lithium plating due to the accumulation of lithium ions, which may pose a high safety risk. Therefore, the gap between the cathode electrode plate and the anode electrode plate in the battery should not be too large. For overhangs between the cathode electrode plate and the anode electrode plate: in the charging and discharging process of a lithium-ion battery, lithium ions are repeatedly deintercalated from the cathode electrode plate and the anode electrode plate. However, when there're no sufficient anode channels for the intercalation of lithium ions deintercalated from the cathode, it may easily lead to lithium-ion accumulation and lithium plating, posing certain product safety risks. Therefore, it is necessary to ensure that the entire cathode electrode plate is within the coverage of the anode, that is, to ensure that the anode exceeds the cathode, or that the overhang of the cathode electrode plate and the anode electrode plate is greater than 0. Therefore, it is necessary to detect the gaps and the overhangs between the cathode electrode plates and the anode electrode plates inside the batteries, and to find internal defects of the batteries in time and reduce the outflow of defective batteries.

In the related art, in order to improve the accuracy of detecting internal defects of batteries, a CCD camera is used to perform detection by photographing circle by circle to detect the overhang between the cathode electrode plate and the anode electrode plate. However, during the test, the camera needs to move to a fixed photographing position and stay for photographing. The process involves pauses and redundant actions that may reduce the test efficiency.

In view of the above, in order to solve the problem of low efficiency in detecting internal defects of batteries, a method combining an X-ray source with a linear array detector is provided to achieve the non-destructive test of the interior of batteries. By locating the battery between the X-ray source and the linear array detector, the X-ray emitted by the X-ray source passes through the battery in a direction perpendicular to the winding axis of the battery electrode plates, and then is received by the linear array detector, thereby acquiring position information and state information of the cathode electrode plate and the anode electrode plate inside the battery, and then detecting various defects inside the battery.

The linear array detector includes a plurality of sensing regions arranged in a first direction. The carrying platform for carrying the battery under test can move in the first direction. The carrying platform is controlled to move in the first direction when the battery under test is being tested. When the battery under test moves between the X-ray source and the linear array detector, the X-ray emitted by the X-ray source passes through the battery under test and then is detected by the linear array detector, thereby achieving the test of the battery under test. Also, since the movement direction of the battery under test is the same as the arrangement direction of the plurality of sensing regions, the battery under test will pass over each sensing region during the movement process. The battery under test is tested during the movement process of the battery under test without staying for detection, thereby reducing the test time and improving the test efficiency.

The testing apparatus and the battery production device disclosed in the embodiments of the present application can be used in the battery production and manufacturing process, and the tested or produced battery cell or battery can be used in, but is not limited to be used in, an electric apparatus, such as a vehicle, a ship, or an aircraft. The power system of the electric apparatus can be composed of the battery cell, the battery, or the like disclosed in the present application.

The embodiments of the present application provide an electric apparatus using a battery as the power source. The electric apparatus may be, but is not limited to, a mobile phone, a tablet, a laptop computer, an electric toy, an electric tool, an electric bicycle, an electric vehicle, a ship, a spacecraft, and the like. The electric toy may include a stationary or mobile electric toy, such as a game console, an electric car toy, an electric ship toy, or an electric airplane toy. The spacecraft may include an airplane, a rocket, a space shuttle, a spaceship, and the like.

In the following embodiments, for ease of description, the present application is illustrated by taking a vehicle 1000 as an example of the electric apparatus according to one embodiment of the present application.

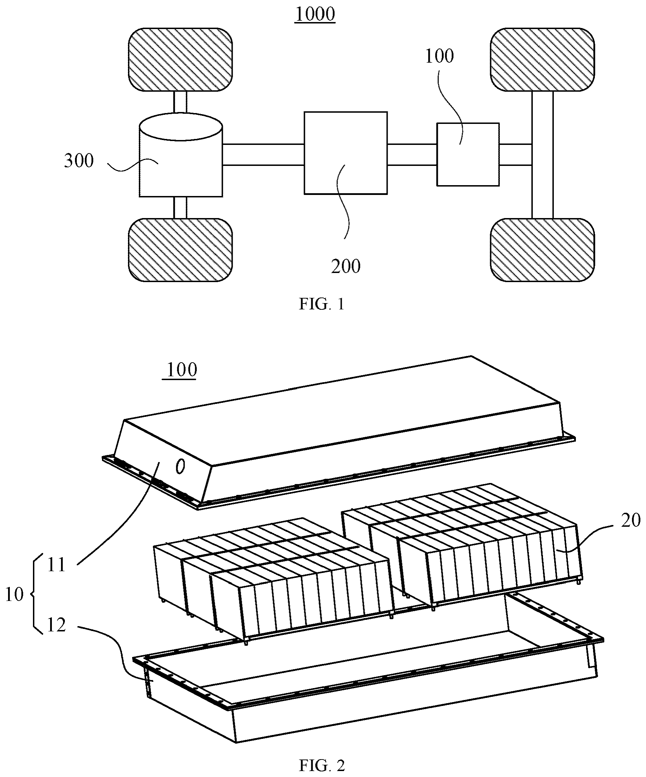

Referring to FIG. 1, FIG. 1 is a schematic view of a vehicle according to some embodiments of the present application. The vehicle 1000 may be a petrol or diesel vehicle, a gas vehicle, or a new energy vehicle. The new energy vehicle may be a pure electric vehicle, a hybrid vehicle, an extended-range vehicle, or the like. A battery 100 is provided inside the vehicle 1000, and the battery 100 may be provided at the bottom, head, or tail of the vehicle 1000. The battery 100 may be configured to power the vehicle 1000. For example, the battery 100 may serve as an operation power source of the vehicle 1000. The vehicle 1000 may further include a controller 200 and a motor 300. The controller 200 is used for controlling the battery 100 to power the motor 300, e.g., for the operation power demand of the vehicle 1000 for startup, navigation, and travel.

In some embodiments of the present application, the battery 100 may not only serve as an operation power source for the vehicle 1000, but also as a travel power source for the vehicle 1000 to, instead of or in part instead of fuel or natural gas, provide the travel power for the vehicle 1000.

Referring to FIG. 2, FIG. 2 is an exploded view of a battery according to some embodiments of the present application. The battery 100 includes a case 10 and battery cells 20. The battery cells 20 are accommodated in the case 10. The case 10 is configured to provide an accommodating space for the battery cell 20, and the case 10 may be of a variety of structures. In some embodiments, the case 10 may include a first part 11 and a second part 12. The first part 11 and the second part 12 are mutually lidded onto each other, and the first part 11 and the second part 12 jointly define an accommodating space for accommodating the battery cells 20. The second part 12 may be of a hollow structure with one end open, and the first part 11 may be of a plate-like structure. The first part 11 is lidded onto the open side of the second part 12, such that the first part 11 and the second part 12 jointly define the accommodating space. The first part 11 and the second part 12 may also each be of a hollow structure with one side open, and the open side of the first part 11 is lidded onto the open side of the second part 12. Certainly, the case 10 formed by the first part 11 and the second part 12 may be in various shapes, such as a cylindrical shape and a rectangular parallelepiped shape.

In the battery 100, there may be a plurality of battery cells 20, and the plurality of battery cells 20 may be connected in series, in parallel, or in series-parallel. The series-parallel connection means that both series connection and parallel connection are present for the connection among the plurality of battery cells 20. The plurality of battery cells 20 may be directly connected in series, in parallel, or in series-parallel, and then the whole formed by the plurality of battery cells 20 is accommodated in the case 10. Certainly, the situation may be that in the battery 100, the plurality of battery cells 20 are first connected in series, in parallel, or in series-parallel to form battery modules, and then the plurality of battery modules are connected in series, in parallel, or in series-parallel to form a whole and accommodated in the case 10. The battery 100 may further include other structures. For example, the battery 100 may further include a busbar component for achieving electrical connection among the plurality of battery cells 20.

Each battery cell 20 may be a secondary battery or a primary battery, or may also be a lithium-sulfur battery, a sodium-ion battery, or a magnesium-ion battery, which, however, is not limiting. The battery cell 20 may be cylindrical, flat, rectangular parallelepiped-shaped, or in other shapes.

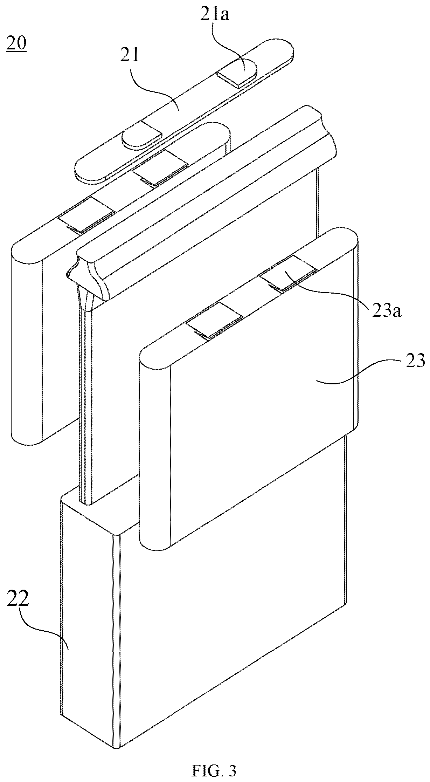

Referring to FIG. 3, FIG. 3 is an exploded view of a battery cell according to some embodiments of the present application. The battery cell 20 refers to the smallest unit forming a battery. As shown in FIG. 3, the battery cell 20 includes an end cover 21, a housing 22, an electrode assembly 23, and other functional components.

The end cover 21 is a component that is lidded onto the opening of the housing 22 to isolate the internal environment of the battery cell 20 from the external environment. Without limitation, the shape of the end cover 21 may be adapted to the shape of the housing 22 to match the housing 22. Illustratively, the end cover 21 may be made of a material with a certain hardness and strength (for example, an aluminum alloy), such that the end cover 21 is not easily deformed when being squeezed or collided. This enables the battery cell 20 to have higher structural strength, and the safety performance can also be improved. Functional components, for example, an electrode terminal 21a, may be disposed on the end cover 21. The electrode terminal 21a may be configured to be electrically connected to the electrode assembly 23 to output or input the electric energy of the battery cell 20. In some embodiments, the end cover 21 may also be provided with a pressure relief mechanism for releasing the internal pressure when the internal pressure or temperature of the battery cell 20 reaches a threshold. The end cover 21 may also be made of various materials, such as copper, iron, aluminum, stainless steel, aluminum alloy, and plastic. In some embodiments, an insulating member may be arranged on the inner side of the end cover 21, and the insulating member may be configured to isolate an electrical connection component in the housing 22 from the end cover 21 to reduce the risk of a short circuit. Illustratively, the insulating member may be made of plastic, rubber, or the like.

The housing 22 is a component configured to form the internal environment of the battery cell 20 in combination with the end cover 21. The formed internal environment may be used to accommodate the electrode assembly 23, electrolytic solution, and other components. The housing 22 and the end cover 21 may be independent components. An opening may be formed in the housing 22, and the end cover 21 is lidded onto the opening to form the internal environment of the battery cell 20. Without limitation, the end cover 21 and the housing 22 may be integrated. Illustratively, the end cover 21 and the housing 22 may form a common connection surface before other components are placed in the housing, and when the interior of the housing 22 needs to be encapsulated, the end cover 21 is lidded onto the housing 22. The housing 22 may be in various shapes and sizes, such as a rectangular parallelepiped, a cylinder, and a hexagonal prism. Illustratively, the shape of the housing 22 may be determined based on the shape and size of the electrode assembly 23. The housing 22 may be made of various materials, such as copper, iron, aluminum, stainless steel, aluminum alloy, and plastic.

The electrode assembly 23 is a component where the electrochemical reaction occurs in the battery cell 20. One or more electrode assemblies 23 may be accommodated in the housing 22. The electrode assembly 23 is mainly formed by winding or stacking a positive electrode plate and a negative electrode plate, and a separator is generally disposed between the positive electrode plate and the negative electrode plate. The portions of the positive electrode plate and the negative electrode plate that contain the active substance constitute the body part of the electrode assembly, and the portions of the positive electrode plate and the negative electrode plate that do not contain the active substance each constitute a tab 23a. The positive electrode tab and the negative electrode tab may be located together at one end of the body part or separately at two ends of the body part. During the charging and discharging process of the battery, the positive electrode active substance and the negative electrode active substance react with the electrolytic solution, and the tabs 23a are connected to the electrode terminals to form a current circuit.

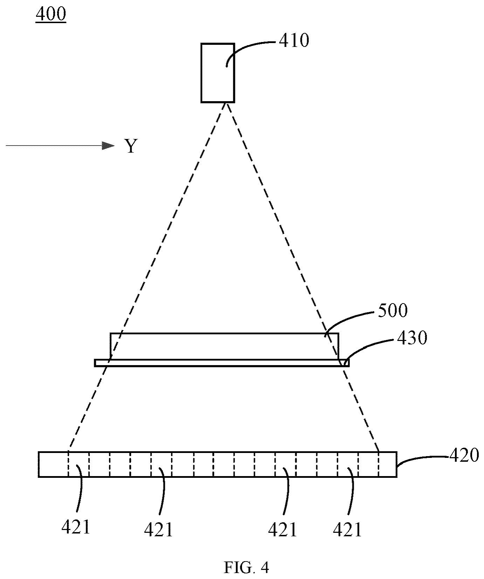

The embodiments of the present application provide a testing apparatus for testing a battery. FIG. 4 is a schematic view of a testing apparatus according to some embodiments of the present application. Referring to FIG. 4, the testing apparatus 400 includes an X-ray source 410, a linear array detector 420, and a carrying platform 430. The linear array detector 420 is opposite to an exit of the X-ray source 410. The carrying platform 430 is movable in a first direction Y, and the carrying platform 430 moves in a trajectory traversing between the X-ray source 410 and the linear array detector 420 and is configured to carry a battery under test 500. For ease of understanding, the battery under test 500 is shown in FIG. 4.

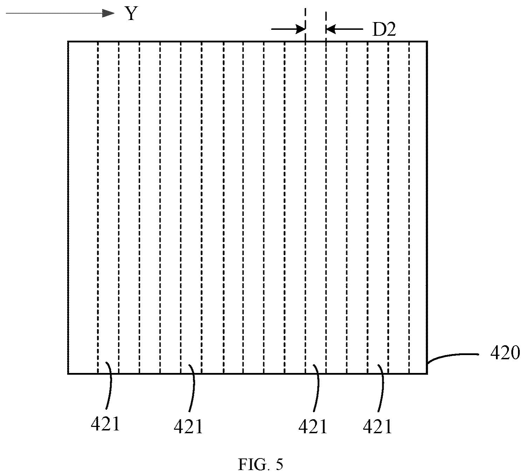

FIG. 5 is a top view of a linear array detector according to some embodiments of the present application. Referring to FIG. 5, the linear array detector 420 includes a plurality of sensing regions 421 arranged in the first direction Y.

The X-ray source 410 is an apparatus for emitting the X-ray, and mainly includes a ray tube and a corresponding power supply. The ray tube may emit the corresponding X-ray. The X-ray source 410 may be open (an open tube) or may be closed (a closed tube). When the X-ray emitted by the X-ray source 410 passes through the battery under test 500, due to the difference in the materials of the cathode electrode plate and the anode electrode plate inside the battery under test 500 (the carbon powder on the surface of the anode electrode has weak absorption capacity for X-rays, while the lithium-ion material on the surface of the cathode electrode has strong absorption capacity for X-rays), the different absorption rates for X-rays, and the interspace between the cathode electrode plate and the anode electrode plate formed in winding, the gap between the cathode electrode plate and the anode electrode plate and the overhang between the cathode electrode plate and the anode electrode plate of the battery under test 500 can be detected by determining the different degrees of X-ray absorption on the cathode electrode plate and the anode electrode plate.

The linear array detector 420 is an apparatus that indirectly or directly converts the X-rays into electric signals to form an image. The linear array detector is mainly composed of a scintillator, a photodiode, semiconductor materials, a detector front end, a control unit, a data acquisition system, and the like. As classified by the conversion process, the linear array detector includes a direct detector and an indirect detector. The direct detector directly converts X-rays into electric signals by using semiconductor materials, wherein the semiconductor materials include cadmium telluride, cadmium zinc telluride, and the like. The indirect detector first converts X-rays into fluorescence signals by using scintillator materials, and then converts the fluorescence signals into electric signals by using the photodiode, wherein the scintillator materials include gadolinium oxysulfide, cesium iodide, and the like. The linear array detector has excellent overall performance, including high sensitivity, a large dynamic range, high work efficiency, or the like.

The carrying platform 430 may be any carrying structure, such as a tray, a clamp, or the like, and may fix the battery under test 500 in a carrying or clamping manner. The carrying platform 430 may be a tray or a clamping mechanism that is provided with and moves along a conveying track. The number of the battery under test 500 carried by the carrying platform 430 may be one or more. In one example, the carrying platform 430 may include a plurality of trays, and each tray carries one or more batteries under test 500. The battery under test 500 may be the battery cell 20 in the above embodiments, or may be the battery 100 including a plurality of battery cells 20.

In the embodiments of the present application, the battery under test 500 is loaded on the carrying platform 430. During the test process, the battery under test 500 moves along with the carrying platform 430 in the first direction Y. When the battery under test 500 moves to a position between the X-ray source 410 and the linear array detector 420, the X-ray emitted by the X-ray source 410 passes through the battery under test 500 and then is detected by the linear array detector 420, thereby achieving the test of the battery under test 500. Also, since the movement direction of the battery under test 500 is the same as the arrangement direction of the plurality of sensing regions 421, the battery under test 500 will pass over each sensing region 421 during the movement process. The battery under test 500 is tested during the movement process of the battery under test 500 without staying for detection, thereby reducing the test time and improving the test efficiency.

According to some embodiments of the present application, the number N of the plurality of sensing regions 421 satisfies: 50 ≤ N ≤ 1100.

Illustratively, the linear array detector 420 includes N sensing regions 421. The battery under test 500 will pass over the N sensing regions 421 at a time. Each time the battery under test 500 passes by a sensing region 421, an imaging signal will be generated. Finally, the imaging signals of each sensing region 421 are superimposed and enhanced to acquire the detection images of the battery under test 500.

A greater number of the sensing regions 421 in the linear array detector 420 may result in a better signal enhancement effect and better detection images. However, correspondingly, the time for analyzing and processing the detection images will increase.

A greater number of the sensing regions 421 in the linear array detector 420 may result in a longer analysis time of detection images and a lower test efficiency, while a smaller number of the sensing regions 421 in the linear array detector 420 may lead to worse effects in acquired detection images and thus affected accuracy of the test results. In the embodiments of the present application, setting the number N of the plurality of sensing regions 421 to 50 ≤ N ≤ 1100 can improve the accuracy of the test results while the analysis time of detection images and thus improving the test efficiency.

According to some embodiments of the present application, the number N of the plurality of sensing regions 421 satisfies: 200 ≤ N ≤ 600.

In some embodiments of the embodiments of the present application, defining the number N of the plurality of sensing regions 421 can improve the accuracy of the test results while the analysis time of detection images and thus improving the test efficiency.

According to some embodiments of the present application, the moving speed V of the carrying platform 430 satisfies: 10 mm/s (millimeters per second) ≤ V ≤ 400 mm/s.

In the embodiments of the present application, the carrying platform 430 moves in the first direction Y.

In some embodiments of the present application, during the test process, the carrying platform 430 may move at a constant speed.

In some other embodiments of the present application, during the test process, the speed of the carrying platform 430 may vary, that is, the carrying platform 430 does not move at a constant speed.

In the embodiments of the present application, the carrying platform 430, when moving, drives the battery under test 500 to move, that is, the moving speed of the carrying platform 430 is equal to the speed of the battery under test 500.

For the linear array detector 420, the moving speed V of the carrying platform 430 is negatively correlated with single frame integration time T0. An excessive moving speed V of the carrying platform 430 may lead to a short single frame integration time T0 and undersampling, resulting in a compressed dimension of the battery under test 500 in the first direction Y and blurred detection images. An insufficient moving speed V of the carrying platform 430 may lead to a long single frame integration time T0 and oversampling, resulting in a stretched dimension of the battery under test 500 in the first direction Y and blurred detection images.

The single frame integration time T0 represents the time required for each sensing region 421 to acquire an image by means of the X-ray emitted by the X-ray source 410.

Assuming that the moving speed of an object under test is V (the moving speed V of the carrying platform 430), the magnification fold of the testing apparatus is M, the number of the sensing regions 421 in the linear array detector 420 is N, and the width of the single sensing region 421 is D2,
the single frame integration time T0 = D2/(M*V).

Under M-fold magnification, when the object under test moves at a constant speed V,
the cumulative integration time of the linear array detector 420 is T = N*T0 = (D2*N)/(M*V).

The signal-to-noise ratio of the detection image is SNR∝√T (SNR = signal/noise). Therefore, a longer cumulative integration time may lead to a better signal-to-noise ratio of the detection image and an easier test.

In the embodiments of the present application, defining the moving speed V of the carrying platform 430 to satisfy: 10 mm/s ≤ V ≤ 400 mm/s can reduce the occurrence of undersampling and oversampling to a certain extent, thereby improving the quality of detection images and the test effect.

According to some embodiments of the present application, the moving speed V of the carrying platform 430 satisfies: 30 mm/s ≤ V ≤ 250 mm/s.

In the embodiments of the present application, defining the moving speed V of the carrying platform 430 can reduce the occurrence of undersampling and oversampling to a certain extent, thereby improving the quality of detection images and the test effect.

According to some embodiments of the present application, the power P of the X-ray source 410 satisfies: 65W (Watt) ≤ P ≤ 75W.

Increasing the dose of the X-ray passing through requires an increased power P of the X-ray source 410, which will increase the workload of the X-ray source 410. Moreover, increasing the power of the X-ray source 410 may increase the focal spot size of the X-ray source 410, and a larger focal spot size may lead to a lower resolution of the linear array detector 420. If the power P of the X-ray source 410 is reduced, the X-ray dose may be reduced and the detection image on the linear array detector 420 may be dimmed.

In the embodiments of the present application, defining the power P of the X-ray source 410 to 65W ≤ P ≤ 75W can improve the resolution of the linear array detector 420 and the brightness of detection images to a certain extent, thereby lifting method the accuracy of the test.

According to some embodiments of the present application, the power P of the X-ray source 410 satisfies: 68W ≤ P ≤ 72W.

In the embodiments of the present application, defining the power P of the X-ray source 410 to 68W ≤ P ≤ 72W can improve the resolution of the linear array detector 420 and the brightness of detection images, thereby lifting method the accuracy of the test.

According to some embodiments of the present application, the rated voltage U of the X-ray source 410 satisfies: 100 kV (kilovolt) ≤ U ≤ 160 kV, and/or the rated current I of the X-ray source 410 satisfies: I ≤ 500 µA.

The maximum X-ray photon energy emitted by the X-ray source 410 is equal to the energy acquired by the incident electron in the accelerating electric field of the ray tube, that is, equal to the electron charge multiplied by the strength of the accelerating electric field. The strength of the accelerating electric field is the magnitude of the tube voltage, that is, the magnitude of the rated voltage U of the X-ray source 410. A higher rated voltage U may result in a higher energy of the generated X-ray, while a smaller wavelength may lead to a stronger ability to pass through an object.

A greater rated current I of the X-ray source 410 may result in more high-speed electrons bombarding the target per unit time and more X-rays emitted by the X-ray source 410, thus leading to an increase in the X-ray dose in a certain area and an increase in the brightness of the corresponding image. However, if the rated voltage U or the rated current I of the X-ray source 410 is excessive, the focal spot size of the X-ray source 410 will also be excessive, which may reduce the resolution of the linear array detector 420 and is undesirable for subsequent image recognition and defect determination.

In the embodiments of the present application, defining the rated voltage U or the rated current I of the X-ray source 410 can provide a test X-ray dose that meets the requirements, ensure the stability and reliability of the X-ray source 410, and enable the coordination of the X-ray source 410 with the linear array detector 420 to meet requirements for the test precision of batteries under test 500 with a greater thickness range, thereby improving the test efficiency and accuracy.

According to some embodiments of the present application, the rated voltage U of the X-ray source 410 satisfies: 130 kV ≤ U ≤ 150 kV, and/or the rated current I of the X-ray source 410 satisfies: I ≤ 400 µA.

In the embodiments of the present application, defining the rated voltage U or the rated current I of the X-ray source 410 can increase the dose of X-ray emitted by the X-ray source 410 and improve the stability and reliability of the X-ray source 410, thereby improving the efficiency and accuracy of the test.

According to some embodiments of the present application, the maximum size D1 of the focal spot of the X-ray source 410 satisfies: D1 ≤ 30 µm (micrometers).

The focal spot size of the X-ray source 410 refers to the size of the focal spot in a certain direction parallel to a plane where the focal spot is located. In the case where other conditions are consistent, a smaller focus indicates a higher resolution and better imaging quality. Common methods for measuring the focal spot size of the X-ray source 410 are classified into a direct method and an indirect method. The direct method refers to directly measuring the shape and size of the focal spot, such as the pinhole method. The indirect method refers to calculating the focal spot size by measuring a point spread function or a line spread function caused by the focal spot size, including the knife-edge method, the slit method, and the spherical target method. The detection may also be performed with reference to methods specified in relevant measurement standards, such as the measurement methods listed in GB/T26834-2011.

Illustratively, when the focal spot of the X-ray source 410 is circular, the maximum size D1 of the focal spot of the X-ray source 410 may be the diameter of the focal spot of the X-ray source 410.

The maximum size D1 of the focal spot is directly related to the image resolution of the battery testing apparatus. Defining the maximum size D1 allows a better match of the test precision of the battery testing apparatus with the size of the battery under test, thereby improving the test accuracy and the test efficiency.

According to some embodiments of the present application, the maximum size D1 of the focal spot of the X-ray source 410 satisfies: D1 ≤ 10 µm.

In the embodiments of the present application, defining the maximum size D1 of the focal spot can improve the test accuracy and the test efficiency.

According to some embodiments of the present application, the width D2 of each sensing region 421 in the plurality of sensing regions 421 satisfies: 50 µm ≤ D2 ≤ 150 µm.

In the embodiments of the present application, the width D2 of the sensing region 421 is a size of the sensing region 421 in the first direction Y.

When the battery under test 500 moves, the linear array detector 420 will calculate the integration time of each sensing region 421 according to the moving speed of the battery under test 500 and the number of the sensing regions 421, so as to divide the image of the battery under test 500 into a plurality of rows. When the X-ray passes through each sensing region 421, a related circuit will add the charges of the sensing region 421 to the charges of the previous sensing region 421, thereby acquiring a charge value of the sum of the charges of the current sensing region 421 and the charges of the previous sensing region 421. In this way, when the charge values of all sensing regions 421 are added, the detection images of the battery under test 500 moving fast can be acquired.

When the battery under test 500 moves at a constant speed, its X-ray projections are sequentially captured by the 1st, 2nd, 3rd, ... , Nth sensing regions 421. The linear array detector 420 will accumulate these signals. Therefore, in the same photographing condition, a greater number of sensing regions 421 will lead to a higher signal-to-noise ratio of the detection image.

When the size of the linear array detector 420 changes, a greater width D2 of the sensing region 421 may lead to a shorter integration time and reduced total test time, thereby improving the test efficiency. A smaller width D2 of the sensing region 421 may result in a relatively greater number of the sensing regions 421 and an improved enhancement effect on detection images, thereby increasing the signal-to-noise ratio in detection images of the battery under test 500. In the embodiments of the present application, defining the width D2 of the sensing region 421 to 50 µm ≤ D2 ≤ 150 µm can improve the signal-to-noise ratio in detection images while improving the test efficiency.

According to some embodiments of the present application, the X-ray source 410 includes an integrated X-ray source.

The integrated X-ray source is a closed X-ray source with an integrated design where the cathode and the anode/target are both enclosed in a vacuum tube, so as to improve the stability and reduce the failure rate, while minimizing the volume of the X-ray source 410 to facilitate the operation and mounting.

According to some embodiments of the present application, the linear array detector includes a tim delay integration (TDI) detector.

The TDI detector is a linear image sensor. A pixel row of the image sensor is perpendicular to the movement direction of an object under test, thereby achieving high-speed and high-resolution image acquisition. The TDI detector can convert the received ray energy into recordable electric signals. By measuring the ray dose received by the TDI detector, electric signals proportional to the ray dose are generated, thereby forming a corresponding image. Illustratively, the TDI detector may include three parts: a ray conversion module, a photoelectric conversion module, and a signal readout and transmission module. In the process of testing the battery under test 500 by the testing apparatus, the battery under test 500 is located in the radiation area of the X-ray source 410, and the X-ray emitted by the X-ray source 410 is emitted from the ray irradiation window. The emitted X-ray passes through the battery under test 500 and is projected to the TDI detector. The TDI detector receives the ray passing through the battery under test 500 and images the battery under test 500.

The TDI detector has a better imaging effect, which makes the detection image closer to the real situation and thus improves the test precision. In addition, the TDI detector can output images with high quality even in a dark circumstance, which may further improve the test precision.

In the embodiments of the present application, when the X-ray intensity is limited, using the TDI detector can correspondingly increase the scanning speed, thereby improving the efficiency; or when the scanning speed is the same, using the TDI detector can reduce the X-ray intensity, thereby saving resources.

In the related art, since the X-ray source 410 emits conical beams, when the battery under test 500 is detected, the distortion at the edge of the battery under test 500 is serious. However, the imaging width of a single sensing region 421 of the TDI detector is narrow, such that the rays almost perpendicularly irradiate the region during imaging. Therefore, for a portion parallel to the pixel row of the TDI detector, the effect of improving the edge distortion is relatively significant.

According to some embodiments of the present application, the testing apparatus 400 may further include a processor. The processor is connected to the linear array detector 420, and is configured to receive the electric signals of the linear array detector 420 to output the test result of the battery under test 500.

The processor may be any computer apparatus that receives the electric signals from the linear array detector 420 to restore the image of the object under test. The processor may further predetermine a corresponding image recognition algorithm. By recognizing the detection image, a corresponding test result may be obtained. According to the test result, whether the battery under test 500 is abnormal is determined. In one example, the processor may recognize the detection image to acquire parameters such as the overhang between the cathode electrode plate and the anode electrode plate and/or the gap between the cathode electrode plate and the anode electrode plate inside the battery under test 500, compare the above parameters with a predetermined threshold, and output a corresponding test result according to the comparison results.

Since the processor is configured to receive the image signals generated by the linear array detector 420, recognize the detection image, and output the test result of the battery under test 500, the internal defects of the batteries under test can be automatically detected, thereby improving the automation degree and the test efficiency of the battery testing apparatus.

The embodiments of the present application provide a battery production device. The battery production device includes the testing apparatus according to any one of the above embodiments.

The battery production device includes a battery testing apparatus, which can perform non-destructive test on the batteries under test 500 in the production process of the batteries under test 500, to find internal defects of the batteries under test 500 in time, thereby excluding unqualified batteries under test 500 and improving the quality of yielded batteries under test 500.

The battery testing apparatus of the present application will be described below in conjunction with an example.

The testing apparatus 400 includes an X-ray source 410, a linear array detector 420, and a carrying platform 430. The linear array detector 420 is opposite to an exit of the X-ray source 410. The carrying platform 430 is movable in a first direction Y, and the carrying platform 430 moves in a trajectory traversing between the X-ray source 410 and the linear array detector 420 and is configured to carry a battery under test 500. The linear array detector 420 includes a plurality of sensing regions 421 arranged in the first direction Y. The X-ray source 410 is an integrated X-ray source, and the linear array detector is a TDI detector.

The number N of the plurality of sensing regions 421 satisfies: 200 ≤ N ≤ 600; the moving speed V of the carrying platform 430 satisfies: 30 mm/s ≤ V ≤ 250 mm/s; the power P of the X-ray source satisfies: 68 W ≤ P ≤ 72 W; the rated voltage U of the X-ray source 410 satisfies: 130 kV ≤ U ≤ 150 kV, and the rated current I of the X-ray source 410 satisfies: I ≤ 400 µA; the maximum size D1 of the focal spot of the X-ray source 410 satisfies: D1 ≤ 10 µm; the width D2 of each sensing region 421 in the plurality of sensing regions 421 satisfies: 50 µm ≤ D2 ≤ 150 µm.

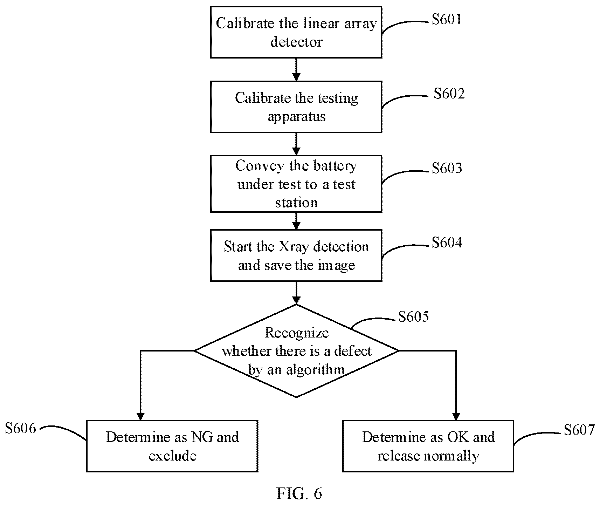

FIG. 6 is a flowchart of a test method of the testing apparatus according to some embodiments of the present application. Referring to FIG. 6, the test method of the battery testing apparatus 400 includes the following steps:
Step S601, calibrating the linear array detector.

To ensure the quality of image detection, the linear array detector 420 needs to be calibrated before startup. Before calibration, it is necessary to ensure that there are no obstructions between the X-ray source 410 and the linear array detector 420, including the carrying platform 430 and other stuff. The X-ray source 410 is turned on for bright field image acquisition, and after the bright field image acquisition, the X-ray source 410 is turned off for dark field image acquisition. The process is repeated three times to calibrate the linear array detector. After the calibration, the correction template is re-activated.

Step S602: calibrating the testing apparatus.

Before calibration, it is necessary to ensure that there are no batteries under test 500 or other stuff between the X-ray source 410 and the linear array detector 420. A calibration block supplied along with the device is placed on a test platform, the scale of the calibration block is adjusted, and the height of a gauge pin installed on the calibration block is half the height of the battery under test 500. The device is turned off, the X-ray source 410 is turned on, and the gauge pin is moved to the middle of the field of view. The relative positions of the X-ray source 410 and the linear array detector 420 are kept consistent with those during the battery test. A software calibration interface is turned on, the diameter of the gauge pin is input, and the software automatically records and stores the magnification.

Step S603: conveying the battery under test to a test station.

The carrying platform 430 is driven to move and sequentially convey the battery under test 500 to the test positions between the X-ray source 410 and the linear array detector 420, and stops moving to wait for the turn-on of the X-ray source for detection.

Step S604: starting the X-ray detection and saving the image.

After the rated voltage U and the rated current I of the X-ray source 410 during detection are set, the X-ray source is turned on, and the X-ray passes through the battery under test 500. The linear array detector 420 receives the X-ray passing through the battery under test 500 and converts the X-ray into an image. Then, the processor reads and saves the image.

Step S605: recognizing whether there is a defect in the image by an algorithm.

A neural network recognition algorithm is used to recognize and measure the overhang between the cathode electrode plate and the anode electrode plate and the gap between the cathode electrode plate and the anode electrode plate inside the battery under test 500 in the image. If it is detected that the overhang between the cathode electrode plate and the anode electrode plate and/or the gap between the cathode electrode plate and the anode electrode plate exceed a predetermined threshold range, step S606, determining the image as NG, is performed, and the corresponding battery under test 500 is automatically excluded to prevent the outflow of defective products. If it is detected in the image that the overhang between the cathode electrode plate and the anode electrode plate and the gap between the cathode electrode plate and the anode electrode plate are within the predetermined threshold range, step S607, determining the image as OK, is performed, and the corresponding battery under test 500 is released normally.

Finally, it should be noted that the above embodiments are only used to illustrate the technical solutions of the present application, rather than limit same. Although the present application has been described in detail with reference to the foregoing embodiments, those of ordinary skill in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of claims and specification of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A testing apparatus for testing a battery, the testing apparatus comprising:
an X-ray source;
a linear array detector opposite to an exit of the X-ray source, the linear array detector comprising a plurality of sensing regions arranged in a first direction; and
a carrying platform movable in the first direction, the carrying platform moving in a trajectory traversing between the X-ray source and the linear array detector and being configured to carry a battery under test.

2. The testing apparatus according to claim 1, wherein the number N of the plurality of sensing regions satisfies: 50 ≤ N ≤ 1100.

3. The testing apparatus according to claim 2, wherein the number N of the plurality of sensing regions satisfies: 200 ≤ N ≤ 600.

4. The testing apparatus according to any one of claims 1 to 3, wherein the moving speed V of the carrying platform satisfies: 10 mm/s ≤ V ≤ 400 mm/s.

5. The testing apparatus according to claim 4, wherein the moving speed V of the carrying platform satisfies: 30 mm/s ≤ V ≤ 250 mm/s.

6. The testing apparatus according to any one of claims 1 to 5, wherein the power P of the X-ray source satisfies: 65 W ≤ P ≤ 75 W.

7. The testing apparatus according to claim 6, wherein the power P of the X-ray source satisfies: 68 W ≤ P ≤ 72 W.

8. The testing apparatus according to any one of claims 1 to 7, wherein the rated voltage U of the X-ray source satisfies: 100 kV ≤ U ≤ 160 kV, and/or the rated current I of the X-ray source satisfies: I ≤ 500 µA.

9. The testing apparatus according to claim 8, wherein the rated voltage U of the X-ray source satisfies: 130 kV ≤ U ≤ 150 kV, and/or the rated current I of the X-ray source satisfies: I ≤ 400 µA.

10. The testing apparatus according to any one of claims 1 to 9, wherein the maximum size D1 of the focal spot of the X-ray source satisfies: D1 ≤ 30 µm.

11. The testing apparatus according to claim 10, wherein the maximum size D1 of the focal spot of the X-ray source satisfies: D1 ≤ 10 µm.

12. The testing apparatus according to any one of claims 1 to 11, wherein the width D2 of each sensing region in the plurality of sensing regions satisfies: 50 µm ≤ D2 ≤ 150 µm.

13. The testing apparatus according to any one of claims 1 to 12, wherein the X-ray source comprises an integrated X-ray source.

14. The testing apparatus according to any one of claims 1 to 13, wherein the linear array detector comprises a TDI detector.

15. A battery production device, the battery production device comprising the testing apparatus according to any one of claims 1 to 14.
